# FASCICULE DE BREVET EUROPEEN

(11) **EP 4 283 660 B1**
(45) Date de publication et mention de la délivrance du brevet: **20.11.2024**
(21) Numéro de dépôt: 23173765.1
(22) Date de dépôt: 16.05.2023
(51) Int. Cl.: H01L 21/18, H01L 21/02, H01L 21/20, H01L 21/762

(54) **PROCÉDÉ DE COLLAGE DIRECT ASSISTÉ PAR DES ÉLEMENTS CATIONIQUES**
DIREKTES KLEBEVERFAHREN MIT UNTERSTÜTZUNG DURCH KATIONISCHE ELEMENTE
METHOD FOR DIRECT BONDING ASSISTED BY CATIONIC ELEMENTS

(30) Priorité: 25.05.2022 FR 2205053
(43) Date de publication de la demande: 29.11.2023
(73) Titulaire: Commissariat à l'Energie Atomique et aux Energies Alternatives, 75015 Paris (FR)
(72) Inventeur: FOURNEL, Frank, 38054 Grenoble Cedex 9 (FR); CALVEZ, Aziliz, 38054 Grenoble Cedex 09 (FR); LARREY, Vincent, 38054 Grenoble Cedex 9 (FR); MORALES, Christophe, 38054 Grenoble Cedex 9 (FR)
(74) Mandataire: Germain Maureau

(56) Documents cités:
- WO-A1-2021/084188
- FR-A1- 2 880 186
- US-A1- 2006 273 068
- US-A1- 2020 392 040

## Description

La présente invention se rapporte au domaine du collage direct. Elle concerne en particulier un procédé de fabrication d'une structure multicouche par collage direct.

Le collage direct est une technique maintenant bien connue et utilisée pour des applications industrielles comme la fabrication de SOI par la société SOITEC ou la société STMicroelectronics pour la production d'imageurs par exemple. Comme on l'entend dans le présent document, le collage direct est un collage spontané entre deux surfaces sans apport de matière à l'interface entre les surfaces collées, et notamment sans couche épaisse de liquide. Il est néanmoins possible d'avoir quelques monocouches d'eau adsorbées sur les surfaces, ce qui représente entre 0.25 nm et 1.25 nm d'épaisseur, de sorte que ces surfaces sont macroscopiquement sèches.

Le collage direct est classiquement réalisé à température ambiante et pression ambiante, mais ce n'est pas une obligation.

Une caractéristique importante du collage direct est son énergie d'adhésion, c'est-à-dire l'energie disponible pour réaliser le collage spontané. Il s'agit de l'énergie qui permet de déformer les deux surfaces pour les mettre en contact à l'echelle atomique afin que le forces de Van der Waals puissent être mises en oeuvre. Par exemple, pour deux surfaces de silicium ou d'oxyde de silicium hydrophile, l'énergie d'adhésion va typiquement de 30 à 100 mJ/m². Cette énergie d'adhésion dirige en partie la durée de la propagation de l'onde de collage, par exemple l'onde de collage se propage de façon classique en 9 secondes pour le collage direct de deux substrats de silicium de 200 mm.

Une autre caractéristique importante du collage direct est son énergie d'adhérence ou autrement appelée son énergie de collage. C'est l'énergie qu'il faut utiliser pour séparer les deux surfaces collées. Par exemple, pour deux surfaces de silicium ou d'oxyde de silicium hydrophile, l'énergie d'adhérence va typiquement de 0.14 J/m² à 6 J/m².

Pour obtenir un collage spontané, on nettoie généralement les surfaces des contaminations organiques et particulaires qui sont très préjudiciables au collage direct. En général le nettoyage est réalisé préalablement sur les surfaces à coller avec une solution à base d'acide Caro obtenue avec un mélange d'acide sulfurique 96% et d'eau oxygénée 30% (3 :1) à 180°C et de SCI (mélange d'ammoniaque 30%, d'eau oxygénée 30% et d'eau déionisée (1 :1 :5)) à 70°C. Alternativement, il est possible d'utiliser d'autres solutions de nettoyage très oxydantes comme, par exemple, des solutions aqueuses contenant de l'ozone ou encore avec un traitement utilisant une exposition à une lumière UV en présence d'ozone gazeux. L'énergie d'adhérence d'un collage SiO₂-SiO₂ (deux substrats de silicium recouvert d'environs 145 nm d'oxyde thermique par exemple), dans une ambiance de salle blanche, avec un nettoyage chimique à base de Caro et de SCI à 70°C, vaut environ 140mJ/m² juste après le collage, sans traitement thermique.

L'énergie de collage évolue également en fonction du traitement thermique que l'on applique après le collage réalisé à température ambiante. L'énergie d'adhérence augmente en fonction de la température des traitements thermiques. Par exemple, l'énergie de collage SiO₂-SiO₂ monte lentement pour atteindre, suivant les traitement de surface, presque 3J/m² à 500°C et stagne ensuite jusqu'à 800°C.

Pour encore augmenter l'énergie de collage, une autre solution consiste à réaliser un traitement plasma préalablement à la mise en contact. Avec un plasma d'azote (N₂), pour un collage oxyde-oxyde, l'énergie de collage monte rapidement à environs 5 J/m² pour une température de traitement de 300°C.

Cependant, l'utilisation d'un plasma peut être incompatible avec certains substrats et/ou son utilisation rallonge les temps et/ou coûts des procédés, ce qui les rend plus difficilement industrialisables. Le traitement plasma modifie aussi la surface sur une épaisseur de quelques nanomètre (entre 1 et 10 nm). Cette modification peut perturber les futurs dispositifs. Par exemple, avec une plaque de silicium, le plasma crée une couche d'oxyde qui est difficilement maîtrisable en terme d'épaisseur et de qualité. Avec une surface d'oxyde de silicium, certains plasmas comme le plasma N2 crée des problèmes de charges interfaciales pouvant perturber le fonctionnement électrique des futurs dispositifs.

D'autres antériorités pertinentes sont le document WO 2021/084188 A1, qui décrit un procédé de collage direct de deux surfaces hydrophiles comprenant, préalablement à l'étape de collage direct, une étape de dépôt d'une molécule spécifique comprenant un groupe fonctionnel hydrophile et un groupe fonctionnel basique; FR 2 880 186 A1, qui décrit un procédé de collage directe de deux substrats, comprenant, préalablement à l'étape de collage direct, une étape de traitement d'une surface oxydée de la première tranche avec une solution de NH4OH/H2O2 pour augmenter la force de collage; US 2006/273068 A1, qui décrit un procédé de liaison directe de deux substrats, comprenant, avant l'étape de liaison directe, une étape de traitement d'une surface oxydée de la première plaquette avec une solution de NH4OH/H2O2 pour augmenter la force de liaison ; et le document US 2020/392040 A1, qui décrit des procédés de fabrication de feuilles de verre minces liées de manière contrôlée sur des supports en verre. Le procédé comprend l'introduction d'une couche de modification comprenant un ou plusieurs tensioactifs cationiques, la couche de modification couplant la première feuille à la seconde feuille.

L'un des buts de la présente invention est de remédier aux inconvénients de l'art antérieur. A cet effet, la présente invention propose un procédé de fabrication d'une structure multicouche par collage direct entre un premier substrat et un second substrat, le procédé comprenant les étapes de :
a) fourniture d'un premier substrat et d'un second substrat comprenant respectivement une première surface de collage et une seconde surface de collage,
b) mise en contact de la première surface de collage et de la seconde surface de collage de sorte à créer une interface de collage direct entre le premier substrat et le second substrat,
c) disposition d'au moins l'interface de collage direct dans une solution aqueuse cationique comprenant de l'eau déionisée et des espèces cationiques issues d'au moins un élément de la première et/ou de la deuxième colonne du tableau périodique des éléments, et
d) application d'un traitement thermique à une température comprise entre 20°C et 350°C de sorte à obtenir la structure multicouche.

Ce procédé de collage direct ainsi réalisé permet d'obtenir une structure multicouche présentant une énergie de collage supérieure à celle d'une structure multicouche obtenue par un procédé de collage direct dépourvu de l'étape c) de traitement dans une solution aqueuse cationique. Une forte énergie de collage est alors obtenue à basse température, c'est-à-dire à des températures inférieures à 400°C, de préférence inférieure ou égale à 350°C et encore de préférence une température de 200°C.

Ces températures de collage sont compatibles avec de nombreuses applications et/ou avec de nombreux substrats, dont la nature et/ou la présence de composants électroniques et/ou opto-électroniques nécessitent de faibles budgets thermiques. De plus, le procédé est applicable à de nombreux matériaux et est peu coûteux. Le procédé conduit à des structures multicouches possédant une bonne tenue mécanique après collage, compatibles avec des procédés ultérieurs comme le Smart Cut^{™} et/ou tout procédé générant des contraintes mécaniques sur l'assemblage, comme par exemple un amincissement mécanique. De plus, ce procédé n'affecte pas l'énergie d'adhésion puisque l'utilisation d'une solution aqueuse cationique n'est réalisée qu'après la mise en contact direct des surfaces. Par exemple, l'onde de collage se propage toujours en 9 secondes pour des substrats de silicium d'environ 200 mm.

Le traitement thermique post collage est également connu par l'homme de l'art sous la dénomination de 'recuit de collage'.

Selon une possibilité, le traitement thermique selon l'étape d) est réalisée par une montée en température, depuis la température ambiante jusqu'à une température finale, la montée en température étant réalisée sur une durée de quelques heures, par exemple 2 heures pour une température finale de 300°C.

Selon une disposition, la température du traitement thermique appliqué à l'étape d) est comprise entre 100°C et 300°C, en particulier entre 150°C et 250°C.

Selon une disposition, l'étape c) de disposition de l'interface de collage direct dans la solution aqueuse cationique est réalisée pendant une durée d'environ 5 min à 40 jours.

La durée de cette étape augmente avec le diamètre du premier et du deuxième substrat. Il est en effet nécessaire que les espèces cationiques aient le temps de se déplacer sur la totalité de l'interface de collage direct pour obtenir une énergie de collage homogène et uniforme Aussi, plus le diamètre de la structure multicouche est grand, plus la durée de l'étape c) est importante.

Aussi, l'étape c) consiste à immerger au moins l'interface de collage direct dans ladite solution aqueuse cationique. Autrement dit, l'assemblage multicouche obtenu à l'étape b) est totalement ou partiellement immergé dans la solution aqueuse cationique dans la mesure où l'interface de collage direct est immergée dans ladite solution aqueuse cationique.

Selon une possibilité, la première surface de collage et/ou la seconde surface de collage est formée au moins en partie par un film hydrophile en un matériau choisi parmi un oxyde natif, un oxyde de silicium thermique ou déposé, un nitrure de silicium, un oxyde de cuivre et une combinaison de ces matériaux.

Typiquement le film hydrophile en oxyde de cuivre est un film hybride composé de plots de cuivre séparés par du SiO2. Les plots de cuivre se recouvrent quasi instantanément à l'air d'un oxyde de cuivre natif.

Lorsque le film hydrophile est en oxyde, il est par exemple formé par un oxyde déposé, un film mince d'oxyde obtenu par un traitement thermique (également appelé oxyde thermique) et/ou un mince film d'oxyde obtenu par un traitement chimique (également appelé oxyde natif ou oxyde chimique).

Selon une variante, le premier et/ou du second substrat sont en matériau(x) oxydé(s), tel que l'alumine, de sorte que la première surface de collage et/ou la seconde surface de collage sont formées par le matériau respectivement du premier et/ou du second substrat car il s'agit d'un matériau intrinsèquement hydrophile. Ceci n'interdit pas la présence d'un film hydrophile en complément.

Selon un mode de réalisation particulier, la première surface de collage est hydrophobe (par exemple en silicium hydrophobe obtenu par passivation de la surface du silicium et greffage d'hydrogène sur le silicium) et la seconde surface de collage est hydrophile. La seconde surface de collage est formée au moins en partie par un film hydrophile choisi parmi un oxyde natif (de silicium, Ge, ... selon le matériau du second substrat), un oxyde thermique (de silicium), un oxyde déposé, un nitrure de silicium, un oxyde de cuivre et une combinaison de ces composés, ou bien la seconde surface de collage est constituée par le matériau du second substrat qui est un oxyde et donc hydrophile. La mise en contact de la seconde surface hydrophile avec la surface hydrophobe change le caractère initial hydrophobe de cette dernière en un caractère hydrophile ce qui permet le collage direct.

Selon une disposition, la première surface de collage et la seconde surface de collage sont totalement planes. Autrement dit, la première et la seconde surface de collage sont dépourvues d'évidement ou de motifs formant des plateaux à l'échelle microscopique.

Selon un mode particulier de mise en oeuvre, la première surface de collage et/ou de la seconde surface de collage sont nettoyées par un traitement à l'eau ozonée et/ou un traitement SC1 et/ou un traitement SC2 avant l'étape b).

Selon une possibilité, le premier substrat et le second substrat présentent un diamètre strictement supérieur à 2,5 cm.

De façon avantageuse, l'étape a) comprend en outre le séchage de la première surface de collage et de la seconde surface de collage avant de réaliser l'étape b) de mise en contact. A l'issu du séchage, la première surface de collage et la seconde surface de collage présentent chacune une face sur laquelle réside au plus une à cinq couches monoatomiques d'H₂O, de sorte que la première surface de collage et la seconde surface de collage sont sèches à l'échelle macroscopique.

Selon une disposition, la solution aqueuse cationique comprend des espèces cationiques choisies parmi le Na⁺, Mg²⁺, Ca²⁺, K⁺, Ba²⁺ et un mélange de ces espèces cationiques.

De manière concrète, la solution aqueuse cationique est formée, par dissolution dans l'eau déionisée, d'un sel choisi parmi le NaCl, MgCl₂, CaCl₂, KCl, BaCl₂, NaF, KCI, KF et un mélange de ces composés.

Selon une possibilité, la solution aqueuse cationique présente une concentration massique des espèces cationiques comprise entre 10⁻⁸g/ml et 0.5 g/ml, notamment entre 10⁻⁸ g/ml et 10⁻² g/ml et en particulier entre 10⁻⁸ g/ml et 10⁻⁴ g/ml. Une faible concentration de cations suffit pour assurer un collage fort ce qui permet une étape de peu coûteuse. Une concentration plus élevée conduit à de moins bons résultats.

Selon une disposition, le premier substrat et le second substrat sont chacun formés par un matériau choisi parmi des matériaux semi-conducteurs, tel que le silicium, les oxydes de silicium, les nitrures de silicium, le SiOC, de l'alumine, du diamant, et une combinaison de ces matériaux, voire le LNO (acronyme pour oxyde de nickel lanthane LaNiO3), le LTO (acronyme de titanate de lithium Li2TiO3) le germanium, l'oxyde de germanium, SiC, InP, AsGa, GaN et une combinaison de ces matériaux.

Le premier substrat et le deuxième substrat peuvent être de nature identique ou de nature différente.

Selon un exemple de réalisation, le premier substrat et le second substrat fournis à l'étape a) comprennent chacun un substrat de silicium présentant un diamètre compris entre 100 mm et 300 mm, en particulier 200 mm, et la première surface de collage et la seconde surface de collage sont chacune formées par un film d'oxyde de silicium de 145 nm par exemple,
l'étape c) comprend la disposition de l'interface de collage direct, obtenue à l'étape b), dans la solution aqueuse cationique sur une durée comprise entre 15 et 20 jours pour des premier et second substrats de 200 mm, la solution aqueuse cationique étant une solution formée par dissolution de NaCl dans l'eau déionisée de sorte à atteindre une concentration massique comprise entre 10⁻⁸ g/ml et 0.001 g/ml et par exemple environ 10⁻⁴ g/ml, et
l'étape d) comprend l'application d'un traitement thermique à environ 300°C, de sorte à obtenir un collage direct entre le premier substrat et le second substrat présentant une énergie de collage supérieure à 5J/m².

L'énergie de collage est mesurée par exemple avec la méthode du double levier à déplacement imposé dans une atmosphère anhydre comme décrit dans l'article de F. Fournel, L. Continni, C. Morales, J. Da Fonseca, H. Moriceau, F. Rieutord, A. Barthelemy, and I. Radu, Journal of Applied Physics 111, 104907 (2012).

Selon une variante de réalisation, le premier substrat fourni l'étape a) comprend une ou plusieurs premières vignettes provenant du vignetage du premier substrat de sorte à obtenir un collage direct de l'une ou plusieurs premières vignettes au second substrat.

La première surface de collage est délimitée par la face exposée de l'une ou plusieurs premières vignettes.

Selon une autre variante, le second substrat fourni à l'étape a) comprend une ou plusieurs secondes vignettes provenant du vignetage du second substrat de sorte à obtenir un collage direct entre l'une ou plusieurs premières vignettes et l'une ou plusieurs secondes vignettes.

La seconde surface de collage est délimitée par la face exposée de l'une ou plusieurs secondes vignettes.

Selon d'autres caractéristiques, le procédé de fabrication de la structure multicouche de l'invention comporte une ou plusieurs des caractéristiques optionnelles suivantes considérées seules ou en combinaison :
- Le premier substrat et/ou le second substrat présentent une épaisseur supérieure à 50 micromètres, de préférence supérieure à 100 micromètres, et par exemple une épaisseur d'environ 725 micromètres. Le premier substrat et/ou le second substrat peuvent être des couches suffisamment épaisses pour être autoportées.
- Le premier substrat et le second substrat sont des empilements d'au moins deux couches de matériau de nature différente.
- La première surface de collage et la seconde surface de collage respectivement du premier et du second substrat sont chacune formées au moins en partie par un film hydrophile en un oxyde natif, un oxyde de silicium, un nitrure de silicium, un oxyde de cuivre .
- La première surface de collage et la seconde surface de collage respectivement du premier et du second substrat sont chacune totalement formées d'un film hydrophile continu en un oxyde natif, un oxyde de silicium, un nitrure de silicium ou un oxyde de cuivre et une combinaison de ces matériaux.
- Seule la première surface de collage ou la seconde surface de collage est hydrophile, au moment de la mise en contact.
- Le premier substrat et/ou le second substrat comprennent des évidements débouchant respectivement à la première et/ou la seconde surface de collage.
- La première surface de collage et la seconde surface de collage sont dépourvues de toute matière ajoutée avant la mise en contact à l'étape b).
- Le procédé comprend avant l'étape b) de mise en contact des surfaces de collage, une étape consistant à appliquer un traitement plasma sur les surfaces de collage des premier et second substrats. Il est ainsi possible de sensiblement diminuer la température du budget thermique tout en conservant une forte énergie de collage.
- Le séchage de la première surface de collage et de la seconde surface de collage comprend une centrifugation des premier et second substrats, en particulier à 2000 tours/min pendant 45 s.
- Le séchage de la première surface de collage et de la seconde surface de collage comprend un séchage utilisant l'effet Marangoni.
- L'étape c) de disposition d'au moins l'interface de collage direct est réalisée dans une solution aqueuse cationique présentant une température comprise entre la température ambiante et 100 °C.
- La solution aqueuse cationique comprend des espèces cationiques choisies parmi le Li, Rb, Sr, le Cs et un mélange de ces espèces.
- La solution aqueuse cationique est formée, par dissolution dans l'eau déionisée, d'un sel choisi parmi le LiCI, RbCI, SrCl2, CsCI et un mélange de ces sels.
- Le premier substrat et le second substrat fournis à l'étape a) comprennent chacun un substrat de silicium présentant un diamètre compris entre 50 mm et de 300 mm, par exemple entre 100 mm et 250 mm, en particulier 200 mm, et la première surface de collage et la seconde surface de collage sont chacune formées par un film d'oxyde de silicium, l'étape c) comprend la disposition de l'interface de collage direct, obtenue à l'étape b), dans la solution aqueuse cationique sur une durée comprise entre 1 et 40 jours, en particulier la solution aqueuse cationique comprend des cations Na+ et présente une concentration massique comprise entre 10⁻⁸ g/ml et 0.01 g/ml notamment entre 10⁻⁸ g/ml et 0.001 g/ml et par exemple de 10⁻⁴ g/ml, et l'étape d) comprend l'application d'un traitement thermique à 300°C, de sorte à obtenir un collage direct entre le premier substrat et le second substrat, le collage direct présentant une énergie de collage supérieure à 5J/m².
- Le premier et le second substrat présentent un diamètre de 50 mm et la durée de l'étape c) est comprise entre environ 1 à 2 jours.
- Le premier et le second substrat présentent un diamètre de 100 mm et la durée de l'étape c) est comprise entre environ 4 à 6 jours.
- Le premier et le second substrat présentent un diamètre de 200 mm et la durée de l'étape c) est comprise entre environ 15 à 20 jours.
- Le premier et le second substrat présentent un diamètre de 300 mm et la durée de l'étape c) est comprise entre environ 35 à 40 jours.

D'autres aspects, buts et avantages de la présente invention apparaîtront mieux à la lecture de la description suivante de plusieurs modes de réalisation de celle-ci, donnée à titre d'exemple non limitatif et faite en référence aux dessins annexés. Dans la suite de la description, par souci de simplification, des éléments identiques, similaires ou équivalents des différentes formes de réalisation portent les mêmes références numériques. Les figures ne respectent pas nécessairement l'échelle de tous les éléments représentés de sorte à améliorer leur lisibilité et dans lesquelles :
La figure 1 représente une vue schématique des étapes a) et b) du procédé selon un mode de réalisation de l'invention.
La figure 2 représente une vue schématique de l'étape c) du procédé selon le mode de réalisation de l'invention.
La figure 3 représente une vue schématique de l'étape d) du procédé selon le mode de réalisation de l'invention.

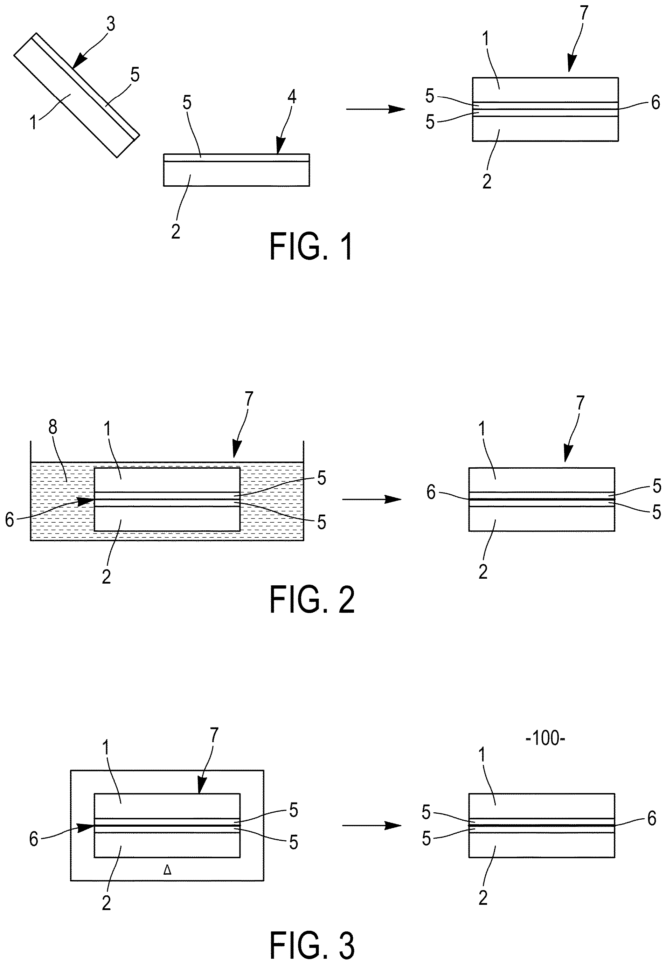

Comme illustré sur les figures 1 à 3, le procédé de la présente l'invention propose un procédé de collage direct entre un premier et un second substrat 1,2 comprenant une étape d'immersion c) dans une solution aqueuse cationique suivi d'une étape de recuit de collage d) à faible température qui permet d'atteindre une forte énergie de collage.

Un premier substrat 1 et un second substrat 2, tous les deux en silicium et présentant chacun une surface de collage 3,4 totalement plane sur un diamètre de 200 mm, sont fournis selon l'étape a) du procédé. Comme visible sur la figure 1, la première surface de collage 3 et la seconde surface de collage 4 sont formées par un film hydrophile 5 d'oxyde de silicium (thermique ou déposé) d'environ 145 nm d'épaisseur. Avant l'étape b) de mise en contact, le procédé comprend un nettoyage à l'eau ozonée des deux surfaces de collage 3,4 et/ou un traitement SC1 (mélange d'ammoniaque 30%, d'eau oxygénée 30% et d'eau déionisée dans les proportions volumiques respectives 1 : 1 : 5) et/ou un traitement SC2 (mélange d'acide chlorhydrique à 30%, d'eau oxygénée à 30% et d'eau dans les proportions volumiques respectives 1 : 1 : 5) de sorte à retirer les contaminants organiques et particulaires qui sont très préjudiciables au collage direct. Les deux surfaces 3 et 4 sont ensuite mises en contact de sorte à créer une interface de collage direct 6 entre les deux substrats 1,2. Selon une possibilité non visible, une seule des deux surfaces de collage 3,4 est formée par un film 5 d'oxyde de silicium. Selon encore une autre possibilité non illustrée, une étape de préparation des première et seconde surfaces de collage 3,4 avant la mise en contact de l'étape b) comprend un traitement au plasma. Dans tous les cas de figures, les première et seconde surfaces de collage 3,4 sont séchées avant l'étape b) de mise en contact, de sorte à retirer l'eau présente à l'échelle macroscopique, par exemple par centrifugation à 2000 tours/min pour obtenir un collage direct spontané.

Une solution aqueuse cationique 8 est alors préparée par dissolution de NaCl dans de l'eau déionisée jusqu'à atteindre une concentration de 10⁻⁴ g/ml en espèce cationique. Comme illustré à la figure 2, l'interface de collage direct 6 (ici la totalité de l'assemblage 7 obtenu à l'étape b) est ensuite immergée dans cette solution 8 selon l'étape c) du procédé. L'immersion est réalisée sur une durée d'environ 20 jours de sorte que les espèces cationiques ont le temps de migrer sur la totalité de l'interface de collage direct 6. Cette durée est moins longue lorsque les substrats 1,2 présentent un diamètre inférieur. Selon une variante de réalisation non illustrée, le premier substrat et/ou le second substrat 1,2 comprennent des évidements débouchant respectivement à la première et/ou la seconde surface de 3,4, créant des cavités à l'interface de collage direct 6. La migration des espèces cationiques à l'interface de collage 6 est alors plus rapide dans ce cas et la durée de l'immersion dans la solution aqueuse cationique 8 peut être réduite.

Un recuit de collage est opéré sur l'assemblage 7 jusqu'à atteindre une température de 300°C selon l'étape d) du procédé (figure 3). A l'issu de ce traitement thermique, la mesure de l'énergie de collage (méthode du double levier) effectuée sur la structure multicouche 100 ainsi obtenue conduit à la casse des substrats 1,2 de silicium et non au décollement des substrats 1,2 à l'interface de collage direct 6. Ceci indique que l'énergie de collage atteinte est supérieure à l'énergie de rupture du silicium, soit une énergie de collage supérieure à 5J/m2. Le même procédé réalisé sans l'étape c) d'immersion dans une solution aqueuse cationique 8 conduit à une énergie de collage de 3J/m2 mesurée selon la même méthode du double levier, après un recuit de collage à 500°C.

Selon une alternative non illustrée, l'un des deux substrats 1,2 fourni à l'étape a) présente un plan de fragilisation. Le traitement thermique de recuit de collage participe au budget thermique permettant une fracture au niveau du plan de fragilisation. La structure multicouche 100 obtenue comprend alors l'un des deux substrats 1,2 collé à une couche mince transférée provenant de la fracture et un négatif de l'autre des substrats 1,2.

Selon encore une autre variante non illustrée le premier substrat 1 fourni à l'étape a) est vigneté en plusieurs premières vignettes dont les faces exposées sont de premières surfaces de collage 3. Les premières vignettes sont collées selon le procédé précédemment décrit sur le seconde substrat 2 (pleine plaque) selon un collage puce-plaque également connu dans la terminologie anglo-saxonne par l'expression 'chip to wafer'. Selon encore une autre variante non illustrée, le second substrat 2 est également vigneté en plusieurs secondes vignettes et le procédé de l'invention permet le collage direct des premières vignettes et des secondes vignettes.

Selon une alternative non illustrée, la première surface de collage 3 et la seconde surface de collage 4 sont préparées de sorte à avoir des surfaces hybrides cuivre-oxyde collables en collage direct. Ces première et seconde surfaces de collage hydrophiles 3,4 sont typiquement composées de plots de cuivre de 2.5 micromètres de côté séparés par 2.5 micromètres de SiO2. On parle alors d'une surface hybride au « pitch » de 5 micromètres. Puis les étape b) à d) du procédé sont reproduites telles que précédemment décrites.

Ainsi, la présente invention propose un procédé de fabrication d'une structure multicouche 100 comportant un collage direct entre deux substrats 1,2 présentant une forte énergie de collage, et permettant de limiter la température du recuit thermique post collage. La solution aqueuse cationique est peu coûteuse et l'étape d'immersion c) est applicable à de nombreux matériaux. Il est notamment possible de coller des substrats (ou couches épaisses) de matériaux ayant une différence significative de coefficient de dilatation thermique. De plus, lorsque les matériaux des premier et second substrats 1,2 comportent des dispositifs, ceux-ci ne sont pas endommagés par les températures utilisées.

Il va de soi que l'invention n'est pas limitée aux variantes de réalisation décrites ci-dessus à titre d'exemple mais que la portée de l'invention est définie par les revendications ci-jointes.

## Revendications

1. Procédé de fabrication d'une structure multicouche (100) par collage direct entre un premier substrat (1) et un second substrat (2), le procédé comprenant les étapes de :
a) fourniture d'un premier substrat (1) et d'un second substrat (2) comprenant respectivement une première surface de collage (3) et une seconde surface de collage (4),
b) mise en contact de la première surface de collage (3) et de la seconde surface de collage (4) de sorte à créer une interface de collage direct (6) entre le premier substrat (1) et le second substrat (2),
c) disposition d'au moins l'interface de collage direct (6) dans une solution aqueuse cationique (8) comprenant de l'eau déionisée et des espèces cationiques issues d'au moins un élément de la première et/ou de la deuxième colonne du tableau périodique des éléments, et
d) application d'un traitement thermique à une température comprise entre 20°C et 350°C de sorte à obtenir la structure multicouche (100).

2. Procédé de fabrication selon la revendication 1, dans lequel l'étape c) de disposition de l'interface de collage direct (6) dans la solution aqueuse cationique (8) est réalisée pendant une durée d'environ 5 min à 45 jours.

3. Procédé de fabrication selon la revendication 1 ou 2, dans lequel la première surface de collage (3) et/ou la seconde surface de collage (4) est formée au moins en partie par un film hydrophile (5) en un matériau choisi parmi un oxyde natif, un oxyde de silicium thermique ou déposé, un nitrure de silicium, un oxyde de cuivre et une combinaison de ces matériaux.

4. Procédé de fabrication selon l'une des revendications 1 à 3, dans lequel la première surface de collage (3) et la seconde surface de collage (4) sont totalement planes.

5. Procédé de fabrication selon l'une des revendications 1 à 4, dans lequel la première surface de collage (3) et/ou de la seconde surface de collage (4) sont nettoyées par un traitement à l'eau ozonée et/ou un traitement SC1 et/ou un traitement SC2 avant l'étape b).

6. Procédé de fabrication selon l'une des revendications 1 à 5, dans lequel la solution aqueuse cationique (8) comprend des espèces cationiques choisies parmi le Na⁺, Mg²⁺, Ca²⁺, K⁺, Ba²⁺ et un mélange de ces espèces cationiques.

7. Procédé de fabrication selon l'une des revendications 1 à 6, dans lequel la solution aqueuse cationique (8) est formée, par dissolution dans l'eau déionisée, d'un sel choisi parmi le NaCl, MgCl₂, CaCl₂, KCl, BaCl₂, NaF, KCI, KF et un mélange de ces composés.

8. Procédé de fabrication selon la revendication 1 à 7, dans lequel la solution aqueuse cationique (8) présente une concentration massique des espèces cationiques comprise entre 10⁻⁸ g/ml et 0.5 g/ml, notamment entre 10⁻⁸ g/ml et 10⁻² g/ml et en particulier entre 10⁻⁸ g/ml et 10⁻⁴ g/ml.

9. Procédé de fabrication selon l'une des revendications 1 à 8, dans lequel le premier substrat (1) et le second substrat (2) sont chacun formés par un matériau choisi parmi des matériaux semi-conducteurs, tel que le Si, les oxydes de silicium, les nitrures de silicium, le SiOC ; l'alumine, le diamant et une combinaison de ces matériaux.

10. Procédé de fabrication selon l'une des revendications 1 à 9, dans lequel :
le premier substrat (1) et le second substrat (2) fournis à l'étape a) comprennent chacun un substrat de silicium présentant un diamètre compris entre 100 mm et 250 mm, en particulier 200 mm, et la première surface de collage (3) et la seconde surface de collage (4) sont chacune formées par un film (5) d'oxyde de silicium,
l'étape c) comprend la disposition de l'interface de collage direct (6), obtenue à l'étape b), dans la solution aqueuse cationique (8) sur une durée comprise entre 15 et 20 jours pour des premier et second substrats de 200 mm, la solution aqueuse cationique (8) étant une solution formée par dissolution de NaCl dans l'eau déionisée de sorte à atteindre une concentration massique comprise entre 10⁻⁸ g/ml et 0.001 g/ml et par exemple une concentration massique d'environ 10⁻⁴ g/ml, et
l'étape d) comprend l'application d'un traitement thermique à environ 300°C, de sorte à obtenir un collage direct entre le premier substrat (1) et le second substrat (2) présentant une énergie de collage supérieure à 5J/m².

## Patentansprüche

1. Verfahren zur Herstellung einer Mehrschichtstruktur (100) durch direkte Verklebung zwischen einem ersten Substrat (1) und einem zweiten Substrat (2), wobei das Verfahren die Schritte umfasst zum:
a) Bereitstellen eines ersten Substrats (1) und eines zweiten Substrats (2), die eine erste Klebefläche (3) beziehungsweise eine zweite Klebefläche (4) umfassen,
b) In-Kontakt-Bringen der ersten Klebefläche (3) und der zweiten Klebefläche (4), so dass eine Grenzfläche der direkten Verklebung (6) zwischen dem ersten Substrat (1) und dem zweiten Substrat (2) geschaffen wird,
c) Anordnen mindestens der Grenzfläche der direkten Verklebung (6) in einer kationischen wässrigen Lösung (8), die deionisiertes Wasser umfasst und kationische Spezies, die aus mindestens einem Element der ersten und/oder der zweiten Spalte des Periodensystems der Elemente hervorgegangen sind, und
d) Anwenden einer Wärmebehandlung bei einer Temperatur zwischen 20 °C und 350 °C, so dass die Mehrschichtstruktur (100) erhalten wird.

2. Herstellungsverfahren nach Anspruch 1, wobei der Schritt c) zur Anordnung der Grenzfläche der direkten Verklebung (6) in der kationischen wässrigen Lösung (8) über einen Zeitraum von etwa 5 min bis 45 Tagen durchgeführt wird.

3. Herstellungsverfahren nach Anspruch 1 oder 2, wobei die erste Klebefläche (3) und/oder die zweite Klebefläche (4) mindestens teilweise durch einen hydrophilen Film (5) aus einem Material gebildet sind, das aus einem nativen Oxid, einem thermischen oder abgeschiedenen Siliciumoxid, einem Siliciumnitrid, einem Kupferoxid und einer Kombination dieser Materialien ausgewählt ist.

4. Herstellungsverfahren nach einem der Ansprüche 1 bis 3, wobei die erste Klebefläche (3) und die zweite Klebefläche (4) vollständig eben sind.

5. Herstellungsverfahren nach einem der Ansprüche 1 bis 4, wobei die erste Klebefläche (3) und/oder die zweite Klebefläche (4) durch eine Behandlung mit ozonisiertem Wasser und/oder SC1-Behandlung und/oder SC2-Behandlung vor dem Schritt b) gereinigt werden.

6. Herstellungsverfahren nach einem der Ansprüche 1 bis 5, wobei die kationische wässrige Lösung (8) kationische Spezies umfasst, die aus Na⁺, Mg²⁺, Ca²⁺, K⁺, Ba²⁺ und einem Gemisch dieser kationischen Spezies ausgewählt sind.

7. Herstellungsverfahren nach einem der Ansprüche 1 bis 6, wobei die kationische wässrige Lösung (8) durch Auflösen in deionisiertem Wasser eines Salzes gebildet wird, das aus NaCl, MgCl₂, CaCl₂, KCl, BaCl₂, NaF, KCI, KF und einem Gemisch dieser Verbindungen ausgewählt ist.

8. Herstellungsverfahren nach Anspruch 1 bis 7, wobei die kationische wässrige Lösung (8) eine Massenkonzentration der kationischen Spezies zwischen 10⁻⁸ g/ml und 0,5 g/ml aufweist, besonders zwischen 10⁻⁸ g/ml und 10⁻² g/ml und insbesondere zwischen 10⁻⁸ g/ml und 10⁻⁴ g/ml.

9. Herstellungsverfahren nach einem der Ansprüche 1 bis 8, wobei das erste Substrat (1) und das zweite Substrat (2) jeweils aus einem Material gebildet sind, das aus Halbleitermaterialien wie Si, Siliciumoxiden, Siliciumnitriden, SiOC, Aluminiumoxid, Diamant und einer Kombination dieser Materialien ausgewählt ist.

10. Herstellungsverfahren nach einem der Ansprüche 1 bis 9, wobei:
das erste Substrat (1) und das zweite Substrat (2), die in Schritt a) bereitgestellt werden, jeweils ein Siliciumsubstrat umfassen, das einen Durchmesser zwischen 100 mm und 250 mm aufweist, insbesondere 200 mm, und die erste Klebefläche (3) und die zweite Klebefläche (4) jeweils durch einen Siliciumoxidfilm (5) gebildet sind,
der Schritt c) die Anordnung der Grenzfläche (6) der direkten Verklebung umfasst, die in Schritt b) erhalten wurde, in der kationischen wässrigen Lösung (8), über einen Zeitraum von 15 bis 20 Tagen, für erste und zweite Substrate von 200 mm, wobei die kationische wässrige Lösung (8) eine Lösung ist, die durch Auflösen von NaCl in deionisiertem Wasser gebildet wird, so dass eine Massenkonzentration zwischen 10⁻⁸ g/ml und 0.001 g/ml erreicht wird, und beispielsweise eine Massenkonzentration von etwa 10⁻⁴ g/ml, und
der Schritt d) die Anwendung einer Wärmebehandlung bei etwa 300 °C umfasst, so dass eine direkte Verklebung zwischen dem ersten Substrat (1) und dem zweiten Substrat (2) erhalten wird, eine Verklebungsenergie von mehr als 5 J/m² aufweisend.

## Claims

1. A method for manufacturing a multilayer structure (100) by direct bonding between a first substrate (1) and a second substrate (2), the method comprising the steps of:
a) providing a first substrate (1) and a second substrate (2) respectively comprising a first bonding surface (3) and a second bonding surface (4),
b) bringing the first bonding surface (3) and the second bonding surface (4) into contact so as to create a direct bonding interface (6) between the first substrate (1) and the second substrate (2),
c) placing at least the direct bonding interface (6) in a cationic aqueous solution (8) comprising deionized water and cationic species originating from at least one element of the first and/or of the second column of the periodic table of elements, and
d) applying a heat treatment at a temperature between 20°C and 350°C so as to obtain the multilayer structure (100).

2. The manufacturing method according to claim 1, wherein step c) of placing the direct bonding interface (6) in the cationic aqueous solution (8) is carried out for a period of approximately 5 min to 45 days.

3. The manufacturing method according to claim 1 or 2, wherein the first bonding surface (3) and/or the second bonding surface (4) is formed at least in part by a hydrophilic film (5) made of a material selected from a native oxide, a thermal or deposited silicon oxide, a silicon nitride, a copper oxide and a combination of these materials.

4. The manufacturing method according to any of claims 1 to 3, wherein the first bonding surface (3) and the second bonding surface (4) are completely flat.

5. The manufacturing method according to any of claims 1 to 4, wherein the first bonding surface (3) and/or the second bonding surface (4) are cleaned by treatment with ozonated water and/or a SC1 treatment and/or a SC2 treatment before step b).

6. The manufacturing method according to any of claims 1 to 5, wherein the cationic aqueous solution (8) comprises cationic species selected from Na⁺, Mg²⁺, Ca²⁺, K⁺, Ba²⁺ and a mixture of these cationic species.

7. The manufacturing method according to any of claims 1 to 6, wherein the cationic aqueous solution (8) is formed, by dissolving in deionized water, a salt selected from NaCl, MgCl₂, CaCl₂, Kel, BaCl₂, NaF, Kel, KF and a mixture of these compounds.

8. The manufacturing method according to claim 1 to 7, wherein the cationic aqueous solution (8) has a mass concentration of the cationic species comprised between 10⁻⁸ g/ml and 0.5 g/ml, in particular between 10⁻⁸ g/ml and 10⁻² g/ml and in particular between 10⁻⁸ g/ml and 10⁻⁴ g/ml.

9. The manufacturing method according to any of claims 1 to 8, wherein the first substrate (1) and the second substrate (2) are each formed by a material selected from semiconductor materials, such as Si, silicon oxides, silicon nitrides, SiOC; alumina, diamond and a combination of these materials.

10. The manufacturing method according to one of claims 1 to 9, wherein:
the first substrate (1) and the second substrate (2) provided in step a) each comprise a silicon substrate having a diameter comprised between 100 mm and 250 mm, in particular 200 mm, and the first bonding surface (3) and the second bonding surface (4) are each formed by a film (5) of silicon oxide,
step c) comprises placing the direct bonding interface (6), obtained in step b), in the cationic aqueous solution (8) over a period comprised between 15 and 20 days for first and second substrates of 200 mm, the cationic aqueous solution (8) being a solution formed by dissolving NaCl in deionized water so as to reach a mass concentration comprised between 10⁻⁸ g/ml and 0.001 g/ml and for example a mass concentration about 10⁻⁴ g/ml, and
step d) comprises the application of a heat treatment at approximately 300° C., so as to obtain direct bonding between the first substrate (1) and the second substrate (2) having a bonding energy greater than 5 J/m².
